(19) Europäisches Patentamt

European Patent Office

Office européen des brevets

(11) Numéro de publication: **0 322 962 B1**

(12) **FASCICULE DE BREVET EUROPEEN**

(45) Date de publication de fascicule du brevet: **02.03.94** (51) Int. Cl.⁵: **H01L 29/08**, H01L 29/73, H01L 29/52

(21) Numéro de dépôt: **88202929.1**

(22) Date de dépôt: **19.12.88**

(54) Circuit intégré présentant un transistor latéral.

(30) Priorité: **30.12.87 FR 8718388**

(43) Date de publication de la demande:
**05.07.89 Bulletin 89/27**

(45) Mention de la délivrance du brevet:
**02.03.94 Bulletin 94/09**

(84) Etats contractants désignés:
**DE FR GB IT NL**

(56) Documents cités:
**EP-A- 0 228 748**
**GB-A- 2 077 491**
**US-A- 3 443 173**

(73) Titulaire: **PHILIPS COMPOSANTS**
**4, rue du Port aux Vins**
**F-92150 Suresnes(FR)**
(84) Etats contractants désignés:
**FR**

(73) Titulaire: **N.V. Philips' Gloeilampenfabrieken**
**Groenewoudseweg 1**
**NL-5621 BA Eindhoven(NL)**
(84) Etats contractants désignés:
**DE GB IT NL**

(72) Inventeur: **Leduc, Pierre**
**Société Civile S.P.I.D.**
**209, rue de l'Université**
**F-75007 Paris(FR)**

(74) Mandataire: **Charpail, François et al**
**Société Civile S.P.I.D.**
**156, Boulevard Haussmann**
**F-75008 Paris (FR)**

**Description**

La présente invention a pour objet un circuit intégré présentant un transistor latéral comportant des régions d'émetteur et de collecteur d'un premier type de conductivité espacées latéralement et disposées à partir de la surface d'une région d'un deuxième type de conductivité opposé au premier, l'espace latéral de ladite région du deuxième type situé entre les régions d'émetteur et de collecteur formant la base du transistor, et comportant des liaisons électriques d'émetteur et de collecteur dont chacune présente au moins une zone en contact électrique à travers des fenêtres d'une couche isolante respectivement avec ladite région d'émetteur et avec ladite région de collecteur, la région d'émetteur présentant une profondeur et un niveau de dopage tels que la longueur de diffusion des porteurs minoritaires injectés verticalement dans celle-ci est supérieure ou égale à l'épaisseur de ladite région, et le rapport entre la surface de ladite région d'émetteur et celle de ladite zone de laison électrique d'émetteur étant au moins égal à 20.

Un tel circuit a été décrit dans la demande de brevet français FR-A-2 592 525 (ou EP-A-0 228 748) déposée par la Demanderesse et intitublée "Procédé de fabrication d'un transistor latéral intégré et circuit intégré le comprenant".

Le transistor latéral tel que décrit dans cette antériorité présente un gain amélioré d'un facteur pouvant atteindre environ 1,4 par rapport aux transistors latéraux réalisés auparavant.

On peut ainsi obtenir des transistors latéraux dont le gain en courant est de l'ordre de 10.

Cependant, un des problèmes cruciaux que posent les transistors latéraux est que leur gain en courant reste très inférieur aux gains en courant des transistors verticaux, qui peuvent être de l'ordre de 50 à 100.

La présente invention a pour objet un circuit intégré présentant un transistor latéral dont le gain en courant se rapproche de celui des transistors verticaux, par exemple un gain de l'ordre de 40.

L'idée de base de l'invention consiste à rompre avec le principe de symétrie gouvernant la géométrie des émetteurs des transistors latéraux. Selon ce principe, le contact d'émetteur est peu éloigné de la jonction émetteur-base, ce qui est censé améliorer l'efficacité de l'injection latérale. Or, la Demanderesse a pu mettre en évidence que, de façon surprenante, on pouvait obtenir un gain en courant remarquablement élevé avec une géométrie dans laquelle une partie notable de la jonction émetteur-base était très éloignée du contact d'émetteur, selon au moins une direction préférentielle.

Le circuit intégré selon l'invention est ainsi caractérisé en ce que la région d'émetteur présente une forme de losange allongé suivant au moins une direction dite longitudinale et tronqué dans cette direction, le rapport entre la plus grande dimension longitudinale et la plus grande dimension transversale étant au moins égal à 5, alors que la zone de liaison électrique d'émetteur occupe une position centrale dans le losange.

Selon un mode de réalisation amélioré quant au courant maximal admissible, la région d'émetteur présente au moins une bande, par exemple sous la forme de losanges raccordés selon la dimension longitudinale, et une pluralité de plots de contact.

Selon un mode de réalisation préféré, la région d'émetteur comporte au moins deux branches selon au moins une première et une deuxième directions dites longitudinales. Pour augmenter le courant maximal admissible, la région d'émetteur peut présenter au moins deux bandes selon au moins lesdites première et deuxième directions dites longitudinales chaque bande présentant une pluralité de plots de contact. Dans le cas où la région d'émetteur présente au moins quatre de telles bandes, au moins un ilôt de collecteur peut être disposé dans l'espace existant entre les bandes.

L'invention sera mieux comprise à la lecture de la description qui va suivre donnée à titre d'exemple non limitatif en liaison avec les dessins qui représentent :

- les figures 1a à 1c respectivement en vue de dessus, en coupe selon AA et en coupe selon BB, un mode de réalisation de l'invention,
- les figures 2a et 2b, respectivement en vue de dessus et en coupe selon CC, d'un transistor lateral qui ne fait pas partie de l'invention, la figure 2C étant un détail agrandi de la figure 2a,
- la figure 3, l'allure de la courbe de gain d'un dispositif selon les figures 2a à 2c,
- la figure 4, un autre mode de réalisation de l'invention,
- les figures 5a et 5b, une variante du mode de réalisation préféré de l'invention.
- et les figures 6 et 7 deux variantes du mode de réalisation préféré de l'invention.

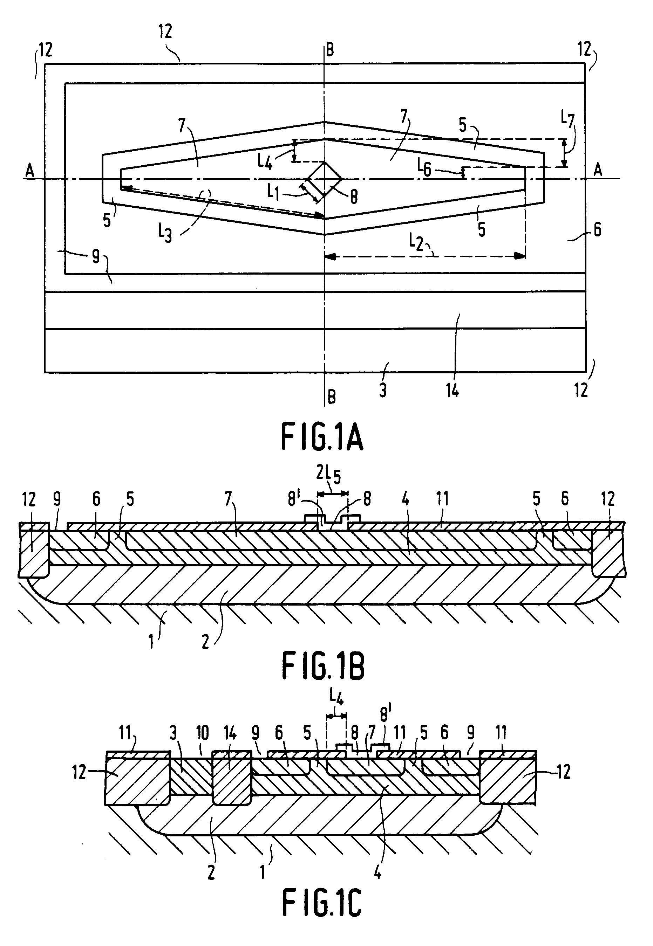

Selon les figures 1a à 1c, un transistor latéral selon l'invention comporte une région d'émetteur 7 en forme de losange allongé et tronqué au centre de laquelle est disposée une ouverture 8 d'une couche d'oxyde mince 11, et servant à la prise de contact d'émetteur.

Le circuit intégré comporte un substrat 1 par exemple de type p dans une région duquel est ménagée une couche enterrée 2 fortement dopée du type opposé, donc $n^+$. Le substrat 1 est recouvert d'une couche épitaxiale de type opposé, donc n, présentant des caissons localisés, ici 4 et 3, formant respectivement un caisson pour le transistor latéral et un caisson de contact de base reliés électriquement l'un à l'autre par la couche enterrée 2 fortement dopée. Le caisson 3 a une forme générale rectangulaire et est séparé du caisson 4 par une région d'oxyde profond 14 qui s'étend jusqu'à la couche enterrée 2. Le caisson 4 est également de dimension rectangulaire et est bordé sur trois côtés par une région d'oxyde profond 12 qui s'étend jusqu'à la couche enterrée 2, et sur la quatrième côté par la région d'oxyde profond 14. Le caisson 3 est bordé sur ses trois côtés non-adjacents du caisson 4 par la région d'oxyde profond 12 qui borde ainsi l'ensemble des deux caissons 3 et 4.

Le caisson 4 comporte des régions ici de type p, formant les régions d'émetteur 7 et de collecteur 6. La région de collecteur 6 est bordée extérieurement par les couches d'oxyde profond 12 et 14. La région de base 5 est constituée par la région de type n du caisson 4 qui subsiste entre les régions 6 et 7.

L'ouverture 8 est, dans le cas d'espèce, de section carrée et ses diagonales sont disposées selon les axes du losange constituant l'émetteur 7. Un plot de contact 8' représenté sur les figures 1b et 1c permet la prise de contact d'émetteur. Le côté de l'ouverture 8 a pour valeur $L_1$ et sa diagonale $2L_5$ vaut $L_1\sqrt{2}$.

Soit $L_2$ la valeur de la demi-diagonale principale du losange et $L_4 + L_5$ la valeur de l'autre demi-diagonale du losange.
Soit $L_3$ la longueur d'un côté du losange et $L_6$ la demi-longueur du petit côté tronquant l'extrémité du losange, d'où :

$$L_4 + L_5 = L_6 + L_7 \qquad (1)$$

et

$$L_3{}^2 = L_2{}^2 + L_7{}^2 \qquad (2)$$

La région d'émetteur 7 a une profondeur h et un niveau de dopage tels que la longueur de diffusion des porteurs minoritaires injectés verticalement dans celle-ci est supérieure ou égale à l'épaisseur de cette région.

On désigne par $J_1$ la densité de courant d'injection latérale des porteurs minoritaires dans la base 5, par $J_m$ la densité de courant d'injection verticale des porteurs minoritaires sous la zone de contact d'émetteur (8), et par $J_0$ la densité de courant d'injection verticale des porteurs minoritaires sous la portion de la couche d'oxyde 11 qui recouvre la région d'émetteur 7.

La Demanderesse a pu montrer que l'expression du gain en courant $\beta$ du transistor latéral pouvait se présenter en première approximation sous la forme :

$$\beta = \frac{I_C}{I_B} = \frac{I_1}{I_m + I_0} = \frac{4J_1(L_3 + L_6)h}{J_m L_1{}^2 + 4J_0\left[L_2\left(L_6 + \dfrac{L_7}{2}\right) - \dfrac{L_1{}^2}{4}\right]}$$

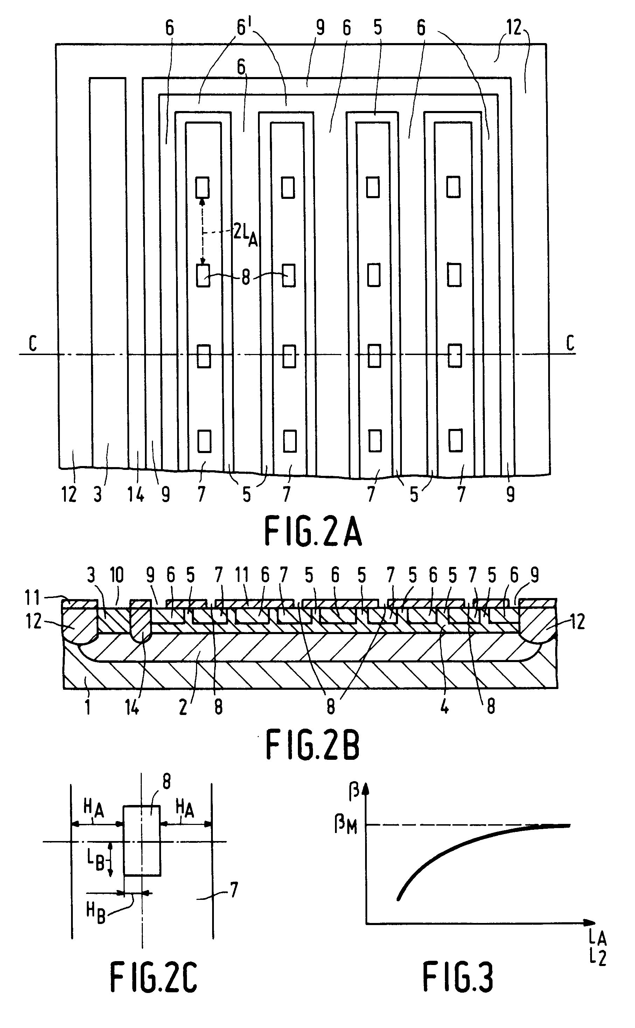

Si on fixe les valeurs de $L_1$, $L_4$ et $L_6$ par exemple aux valeurs minimales permises par le procédé, et si on fait varier la valeur $L_2$, on obtient une courbe de gain $\beta$ dont l'allure est représentée à la figure 3. Le gain $\beta$ augmente avec la valeur de $L_2$ et tend vers une valeur maximale $\beta_M$ lorsque $L_2$ tend vers l'infini.
On a :

EP 0 322 962 B1

$$\beta = \frac{\dfrac{4J_1}{J_0} h (L_6 + \sqrt{L_2{}^2 + L_7{}^2})}{(\dfrac{J_m}{J_0} - 1)L_1{}^2 + 4L_2(L_6 + \dfrac{L_7}{2})}$$

$$\beta_M = \frac{\dfrac{J_1}{J_0} h}{L_6 + \dfrac{L_7}{2}} \qquad\qquad\qquad (3)$$

avec $\dfrac{J_1}{J_0} h = 270 \mu m$, $L_1 = 3 \mu m$, $L_4 = 2 \mu m$ et $L_6 = 2 \mu m$, il vient

$$\beta_M = \frac{270}{3,05} \simeq 89$$

Selon cette géométrie, la valeur du gain augmente constamment lorsque le rapport entre la surface de contact d'émetteur et la surface de la région d'émetteur augmente. Ce résultat est tout à fait surprenant pour deux raisons. D'une part, il met en évidence un cas particulier où la valeur du gain ne passe pas par un maximum contrairement à l'enseignement de la demande de brevet français FR-A-2 592 525 précitée, et d'autre part la valeur maximale du gain $\beta_M$ est plusieurs fois supérieure à celle que permettait d'obtenir la demande précitée.

En effet, selon cette antériorité, on a :

$$\beta opt = \frac{J_1 h}{2J_0} \times \frac{1}{L_1 \sqrt{\dfrac{J_m}{J_0}} - 1}$$

avec

$$\frac{J_m}{J_0} = 35$$

et les mêmes valeurs que précédemment pour $L_1$ et

$$\frac{J_1}{J_0}$$

il vient $\beta_{opt} \simeq 7,8$.

La comparaison des formules donnant les gains maximaux dans les deux cas, respectivement $\beta_M$ et $\beta_{opt}$, montre que, selon la présente invention, le gain maximal $\beta_M$ ne dépend que du rapport

$$\frac{J_1}{J_0}.$$

En d'autres termes, le gain du transistor est pratiquement uniquement la conséquence de l'injection latérale induite par l'injection sous l'oxyde, cette injection sous oxyde étant elle-même la conséquence de l'injection sous la région de contact d'émetteur. C'est justement la forme allongée de l'émetteur selon une direction privilégiée qui permet de mettre pleinement à profit ce phénomène d'injection sous l'oxyde, qui était généralement perçu comme étant un phénomène indésirable.

4

Selon les figures 2a à 2c qui ne font pas partie de l'invention, l'émetteur 7 comprend une pluralité de bandes 7, chaque bande comportant une bande de contact d'émetteur formant une pluralité de contacts à travers des ouvertures 8. Les plots de contact 8′ (non représentés) sont interconnectés par des bandes conductrices elles-même interconnectées. Les autres éléments substrat 1, couche enterrée 2, caissons 3 et 4, etc... portent les mêmes numéros de référence qu'aux figures 1a à 1c.

Plus particulièrement, cette structure en bandes se manifeste (voir la coupe CC de la figure 2b), par une succession de bandes de régions d'émetteur 7 et de collecteur 6 séparées par des bandes de région de base 5.

A l'extrémité des bandes de régions de base, les bandes de régions de collecteur 6 sont reliées entre elles par des sections 6′.

Soit $2L_A$ la distance entre deux ouvertures 8, soit $H_A$ la distance séparant le bord d'une ouverture 8 du bord de la bande d'émetteur correspondante 7 ; soit $L_B$ la demi-longueur d'une ouverture 8 et soit enfin $H_B$ la demi largeur d'une ouverture 8.

Le gain en courant $\beta$ peut alors s'écrire :

$$\beta = \frac{I_C}{I_B} = \frac{(L_A + L_B)J_1 h}{H_B L_B J_m + [(H_A + H_B)(L_A + L_B) - H_B L_B]J_O}$$

Si on fixe les valeurs de $H_A$, $H_B$ et $L_B$, par exemple aux valeurs minimales permises par le procédé et si on fait varier la valeur de $L_A$, on obtient une courbe de gain $\beta$ dont l'allure est représentée à la figure 3. Le gain $\beta$ augmente avec la valeur de $L_A$ et tend vers une valeur maximale $B_M$ lorsque $L_2$ tend vers l'infini. On remarquera que les courbes $\beta(L_2)$ et $\beta(L_A)$ ne sont pas superposables, la figure 3 ne donnant que l'allure de ces courbes. De même, les valeurs de $\beta_M$ ne sont pas rigoureusement les mêmes dans les deux cas

$$\text{Il vient : } \beta = \frac{J_1/J_O(L_A + L_B)h}{(J_m/J_O - 1)H_B L_B + (H_A + H_B)(L_A + L_B)}$$

$$\beta_M = \frac{I_C}{I_B} = \frac{J_1 h}{J_O(H_A + H_B)}$$

avec $H_A = 2\mu m$ et $H_B = 1\mu m$, on a alors :
$\beta_M = 90$

En pratique, le gain en courant est limité par la résistance d'émetteur induite dans le cas des figures 1a à 1c, par la longueur de l'émetteur, et dans le cas des figures 2a et 2b, par l'espacement entre les régions de contact d'émetteur.

En effet, dans l'un et l'autre cas, la résistance d'émetteur tend à abaisser le courant maximal admissible, le gain en courant commençant à chuter à partir d'un certain niveau de courant. Il faut donc choisir dans le premier cas la longueur des losanges et dans le second cas l'espacement entre les contacts d'émetteur de manière à concilier un gain élevé avec une résistance d'émetteur acceptable. La structure qui comporte plusieurs bandes en parallèle permet de multiplier le courant maximal du transistor. Cette structure est donc particulièrement intéressante et permet d'obtenir en général une meilleure optimisation qu'une structure à une seule bande. Par contre, une structure comportant une seule bande d'émetteur est intéressante pour des fonctionnements à faibles ou très faibles courants pour lesquels seul le gain en courant du transistor a une importance.

Nous allons maintenant donner quelques exemples destinés à montrer quelles valeurs de gain peuvent être obtenus en pratique. Les formules de calcul de gain données ci-dessus mettent en oeuvre un modèle théorique simplifié, 1er cas : émetteur en forme de losange tronqué, mêmes valeurs de

$$\frac{J_1}{J_O}$$

$L_1$, $L_4$ et $L_6$ que dans l'exemple précédent, et

$$\frac{J_m}{J_O} = 35$$

pour

$L_2 = 10\mu m$ on a $\beta = 26$
$L_2 = 20\mu m$ on a $\beta = 43$

Pour obtenir un gain amélioré significatif, on considère qu'il faut que :

$L_2 \geq 5(L_4 + L_5)$

2eme cas : émetteur présentant une ou plusieurs bandes ; mêmes valeurs de $H_A$ et $H_B$ que précédemment, et

$$\frac{\bar{J_m}}{J_O} = 35,$$

$L_B = 2,5\mu m$.
pour

$L_A = 10\mu m$ on a $\beta = 27,5$
$L_A = 20\mu m$ on a $\beta = 40$

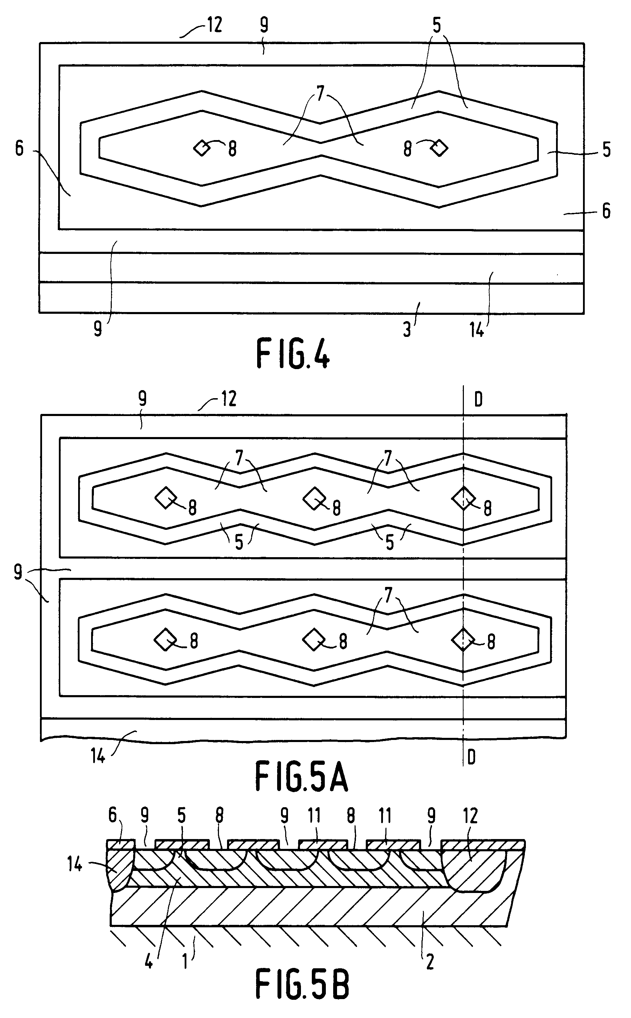

La figure 4 représente une variante de l'invention, dans laquelle l'émetteur comporte une bande constituée par deux losanges tronqués raccordés entre eux.

Les figures 5a et 5b représentent une autre variante de l'invention dans laquelle l'émetteur comporte deux bandes constituées chacune par plusieurs losanges tronqués raccordés entre eux, ici au nombre de trois par bande.

Ces deux variantes permettent un gain légèrement amélioré à largeur égale par rapport à des bandes rectilignes.

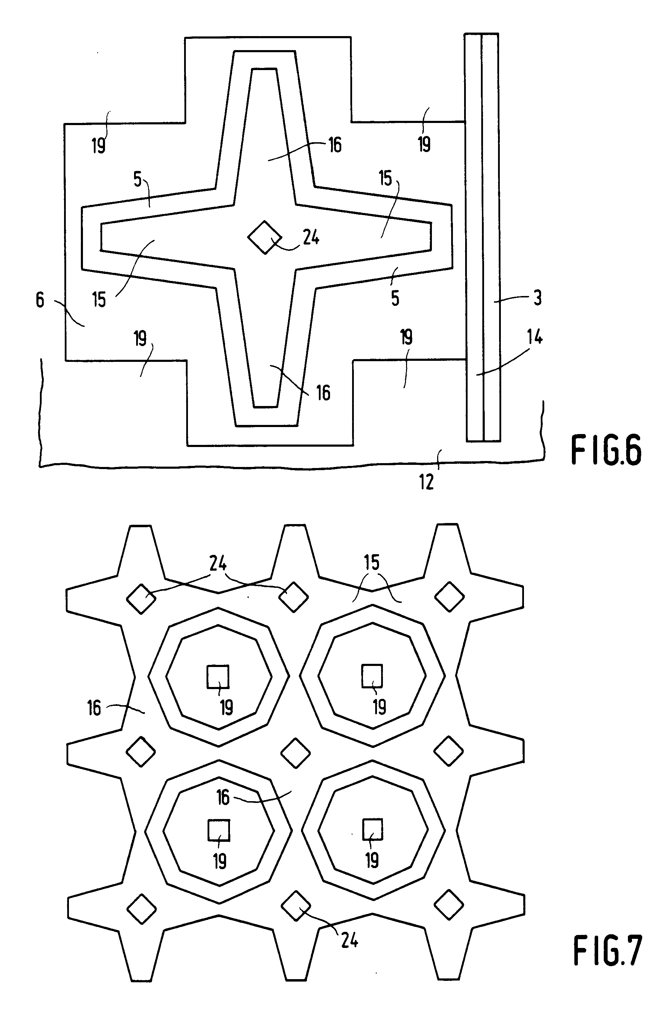

Selon la figure 6, l'émetteur comporte deux branches 15 et 16 disposées selon deux directions dites longitudinales, à l'intersection desquelles est disposé un contact d'émetteur 24. Les deux branches 15 et 16 sont représentés ici comme deux losanges orthogonaux de même centre. Le périmètre de l'émetteur est entouré par la région de base 5 elle-même entourée par la région de collecteur 6, qui comporte une zone de prise de contact d'émetteur 19. Comme dans les modes de réalisation précédents, une couche 14 d'oxyde profond sépare le caisson 3 servant à la prise de contact de base.

Cette structure à deux branches (ou plus) permet de limiter l'encombrement tout en permettant une résistance d'émetteur plus réduite, ce qui permet de maintenir la valeur élevée du gain à des courants plus élevés.

Cette disposition selon plusieurs dimensions présente également l'avantage de se prêter à une réalisation en damier, selon deux directions ou plus, permettant d'autmenter les possibilités en courant, donc en puissance.

Un mode de réalisation est représenté à la figure 7 selon laquelle des structures élémentaires à deux branches selon la figure 6 sont assemblées par l'extrémité des branches, constituant à leur tour des bandes disposées selon les deux directions longitudinales. Lorsqu'il existe au moins quatre de telles bandes, au moins un îlot de collecteur peut être disposé dans l'espace existant entre les bandes. A la figure 7, ont été représentées six bandes et quatre îlots. Chaque îlot présente un contact de collecteur 19.

**Revendications**

1. Circuit intégré présentant un transistor latéral comportant des régions d'émetteur (7) et de collecteur (8) d'un premier type de conductivité espacées latéralement et disposées à partir de la surface d'une région (4) d'un deuxième type de conductivité opposé au premier, l'espace latéral de ladite région du deuxième type situé entre les régions d'émetteur et de collecteur formant la base (5) du transistor, et comportant des liaisons électriques d'émetteur (8,24) et de collecteur (9) chacune présente au moins une zone en contact électrique à travers des fenêtres d'une couche isolante (11) respectivement avec ladite région d'émetteur et avec ladite région de collecteur, la région d'émetteur présentant une profondeur et un niveau de dopage tel que la longueur de diffusion des porteurs minoritaires injectés verticalement dans celle-ci est supérieure ou égale à l'épaisseur de ladite région, et le rapport entre la surface de ladite région d'émetteur et celle de ladite zone de liaison électrique d'émetteur étant au moins égal à 20, caractérisé en ce que ladite région d'émetteur (7) présente une forme de losange allongé suivant au moins une direction longitudinale et tronqué dans cette direction, le rapport entre la plus grande dimension longitudinale et la plus grande dimension transverale étant au moins égal à 5, alors que la zone de liaison électrique d'émetteur (8,24) occupe une position centrale dans le losange.

2. Circuit intégré selon la revendication 1, caractérisé en ce qu'il comporte, au moins une bande de losanges raccordés selon la dimension longitudinale et un plot de contact pour chaque losange de la bande.

3. Circuit intégré selon la revendication 1, caractérisé en ce que la région d'émetteur (7) comporte au moins deux branches (15, 16) selon au moins une première et une deuxième direction longitudinales.

4. Circuit intégré selon la revendication 3 caractérisé en ce que la région d'émetteur (7) comporte au moins deux bandes selon lesdites première et deuxième direction longitudinales, chaque bande présentant une pluralité de plots de contact d'émetteur (24).

5. Circuit intégré selon la revendication 3, caractérisé en ce que la région d'émetteur (7) comporte au moins quatre bandes, et au moins un îlot de collecteur disposé dans l'espace existant entre les bandes.

## Claims

1. An integrated circuit having a lateral transistor comprising emitter (7) and collector (6) regions of a first conductivity type laterally spaced apart and extending from the surface of a region (4) of a second conductivity type opposite to the first type, the lateral space of the said region of the second type situated between the emitter and collector regions forming the base (5) of the transistor and comprising electrical emitter (8, 24) and collector connections (9), each of which has at least one zone in electrical contact with the said emitter region and with the said collector region, respectively, through windows of an insulating layer (11), the emitter region having a depth and a doping level such that the diffusion length of the minority charge carriers vertically injected into the latter region is greater than or equal to the thickness of the said region, while the ratio between the surface area of the said emitter region and that of the said zone in electrical contact with the emitter is at least equal to 20, characterized in that the emitter region (7) has an elongate diamond shape truncated in this direction in at least a longitudinal direction, the ratio between the greatest longitudinal dimension and the greatest transverse dimension being at least equal to 5, while the electrical contact zone (8, 24) of the emitter occupies a central position in the diamond shape.

2. An integrated circuit as claimed in Claim 1, characterized in that it comprises at least one strip of diamonds joined together in the longitudinal direction and a bond pad for each diamond of the strip.

3. An integrated circuit as claimed in Claim 1, characterized in that the emitter region (7) comprises at least two branches (15, 16) extending in at least a first and one second longitudinal direction.

4. An integrated circuit as claimed in Claim 3, characterized in that the emitter region (7) comprises at least two strips in the said first and second longitudinal directions, each strip having a plurality of emitter bond pads (24).

5. An integrated circuit as claimed in Claim 3, characterized in that the emitter region (7) comprises at least four strips and at least one collector island arranged in the space existing between the strips.

## Patentansprüche

1. Integrierte Schaltung, die mit einem Lateraltransistor versehen ist, der seinerseits Emitter- (7) und Kollektor-Bereiche (8) eines ersten Leitungstyps aufweist, die seitlich voneinander getrennt und an der Oberfläche eines Bereiches (4) eines zweiten, dem ersten entgegengesetzten Leitungstyps angeordnet sind, wobei der seitliche Raum des genannten Bereichs des zweiten Leitungstyps zwischen den Emitter- und Kollektorbereichen die Basis (5) des Transistors bildet, und der elektrische Emitter- (8, 24) und Kollektorverbindungen (9) hat, von denen jeder mindestens eine durch Fenster in einer Isolierschicht (11) hindurchgehende elektrische Kontaktzone einerseits mit dem Emitter- und andererseits mit dem Kollektorbereich aufweist, wobei der Emitterbereich eine solche Tiefe und ein solches Dotierungsniveau hat, daß die Diffusionslänge von senkrecht darin injizierten Minoritätsträgern größer oder gleich der Tiefe des genannten Bereiches ist, und das Flächenverhältnis zwischen der Oberfläche des genannten Emitterbereichs und der Zone der elektrischen Emitterverbindung dabei mindestens 20:1 beträgt, dadurch gekennzeichnet, daß der genannte Emitterbereich (7) die Form einer zumindest in einer Längsrichtung langgezogenen und in dieser Richtung beschnittenen Raute aufweist, wobei das Verhältnis zwischen der größten Längsabmessung und der größten Querabmessung mindestens 5:1 beträgt und die Zone der elektrischen Emitterverbindung (8, 24) in der Mitte der Raute liegt.

2. Integrierte Schaltung nach Anspruch 1, dadurch gekennzeichnet, daß sie mindestens einen Streifen aus in Richtung der Längsabmessung aneinandergereihten Rauten und eine Kontaktfläche für jede Raute dieses Streifens aufweist.

3. Integrierte Schaltung nach Anspruch 1, dadurch gekennzeichnet, daß der Emitterbereich (7) mindestens zwei Zweige (15, 16) in mindestens einer ersten und einer zweiten Längsrichtung aufweist.

4. Integrierte Schaltung nach Anspruch 3, dadurch gekennzeichnet, daß der Emitterbereich (7) mindestens zwei Streifen in der ersten und der zweiten Längsrichtung enthält, wobei jeder Streifen eine Vielzahl von Emitter-Kontaktflächen (24) aufweist.

5. Integrierte Schaltung nach Anspruch 3, dadurch gekennzeichnet, daß der Emitterbereich (7) mindestens vier Streifen enthält sowie mindestens eine Kollektorinsel im Zwischenraum zwischen den Streifen.

FIG.1A

FIG.1B

FIG.1C

FIG.2A

FIG.2B

FIG.2C

FIG.3

FIG.4

FIG.5A

FIG.5B

**FIG.6**

**FIG.7**